# EUROPEAN PATENT APPLICATION

(11) **EP 4 475 639 A1**
(43) Date of publication of application: **11.12.2024**
(21) Application number: 23177154.4
(22) Date of filing: 05.06.2023
(51) Int. Cl.: H05K 3/30, H05K 1/18

(54) **HOLDER FOR A SURFACE-MOUNT DEVICE, ASSEMBLY, AND CIRCUIT CARRIER**

(71) Applicant: Magna Electronics Sweden AB, 447 37 Vårgårda (SE)
(72) Inventor: PALII, Alexandru, 700051 Iasi (RO); PADURARIU, Catalin, 700051 Iasi (RO)
(74) Representative: Reichert & Lindner Partnerschaft Patentanwälte

(57) **Abstract**

A holder (1) for an SMD (2) has a frame (10) for receiving the SMD (2), electric contacts (11) for contacting the SMD (2), and electric contacts (12) for connecting to an environment. An assembly (3) of the holder (1) and an SMD (2) contacted to the holder (1) is mounted on a circuit carrier (4). The frame (10) of the holder (1) may have various angles (15) relative to a plane (40) defined by the circuit carrier (4). The assembly (3) may be in thermal contact with a heat sink (5).

## Description

The invention relates to surface-mount technology, especially to a holder for a surface-mount device, an assembly of a holder and a surface-mount device, and a circuit carrier including such an assembly.

Surface-mount technology is an established approach by which various devices can be integrated into electronic circuits, which devices often perform functions other than purely electronic ones. Such devices may operate as light sources (e.g., light emitting diodes), photodetectors, etc.

For example, cameras in driver monitoring systems in the automotive sector use light emitting diodes (LEDs) operating in the infrared portion of the electromagnetic spectrum. These LEDs are mounted on a surface on one side of a printed circuit board (PCB), a contact portion of the LED in contact with electric conductors on the PCB. The operation of these LEDs produces heat resulting in high temperatures of the devices and surrounding portions of the PCB, requiring cooling. For cooling, a heat sink is often provided on the opposite side of the PCB, opposite the LED. A thermal paste or thermal pad may be employed to improve thermal contact to the heat sink. However, as the heat sink is on the side of the PCB opposite the LED, the heat from the LED has to pass through the PCB before it can reach the heat sink or the thermal paste/pad. The thermal conductivity of a PCB typically is much lower than that of aluminium or copper, so the efficiency of cooling by the heat sink through the PCB is low. The resulting high temperature of the LED can have a negative impact on devices and electronic components close by. Another issue with such LEDs in the context of driver monitoring systems is the required angle of emission. For a surface-mount LED on a PCB the emission is symmetric about an axis perpendicular to the PCB. The angle of emission of LEDs readily available on the market does seldom exceed 80 degrees. Driver monitoring systems require emission into an angle of about 120 degrees. A possible solution to this is a complex housing design having at least two LEDs (each with an angle of emission of 80 degrees) arranged at an angle to each other so that the desired 120 degrees of light emission are achieved as an overlap of the emissions from the two LEDs.

Furthermore, it is to be noted that the arrangement of a surface-mount device, like an LED, on the surface of a PCB provides little to no mechanical protection for the device.

Therefore, an improved approach to surface-mounting of devices is required.

It is the object of the invention to provide an approach to surface-mounting which addresses at least some of the problems described above.

This object is achieved by the current invention in several stages: Claim 1 relates to a holder for a surface-mount device. Claim 3 relates to a corresponding assembly including such a holder and a surface-mount device. Claim 4 relates to a corresponding circuit carrier including such an assembly. The dependent claims relate to advantageous embodiments.

The holder according to the invention for a surface-mount device includes a frame for receiving a contact portion of the surface-mount device within the frame. The contact portion of the surface-mount device carries electric contacts used in prior art to connect to one or more electric conductors of circuitry, on a PCB for example. The frame defines a position of the surface-mount device in the holder and secures the surface-mount device at this defined position, at least to some degree. The frame also provides a contact surface for handling the surface-mount device.

The holder has a first set of electric contacts within the frame, for electrically contacting the contact portion of the surface-mount device. For example, electric contacts in the contact portion may be soldered to contacts in the first set of electric contacts. The holder has a second set of electric contacts outside of the frame, for electrically connecting to electric conductors external to the holder, for example on a PCB. The second set of electric contacts is in electrical connection with the first set of electric contacts. In this way, the contact portion of the surface-mount device may be electrically connected to electric conductors external to the holder, via the first set of electric contacts and the second set of electric contacts. The holder is the key to more flexibility in the mounting of the surface-mount device in comparison to directly mounting the surface-mount device, for example to a PCB.

In an embodiment, the second set of electric contacts defines a plane. For example, the contact surfaces of the contacts in the second set of electric contacts may all lie within a plane, and in this way define this plane. An angle of the frame of the holder relative to this plane is adjustable. Adjusting this angle may for example be done by bending contacts of the second set of electric contacts. This is not possible if the surface-mount device is mounted directly to a PCB. If the surface-mount device is an LED, light from the LED can be directed into a desired direction by adjusting this angle.

An assembly according to the invention includes a holder according to the invention as described above and a surface-mount device; a contact portion of the surface-mount device is inserted into the frame of the holder and in electrical contact with the first set of electric contacts. Contacts of the contact portion may be soldered to contacts of the first set of electric contacts. Advantages of an assembly according to the invention have been discussed above in the context of the holder, as these advantages are enabled by the holder.

A circuit carrier according to the invention includes electrical circuitry and an assembly according to the invention as described above. The second set of electric contacts of the holder of the assembly is in electrical connection with one or more electric conductors of the electrical circuitry. The circuit carrier may be a printed circuit board, but the circuit carrier is not limited thereto. The surface-mount device in the assembly, without being limited thereto, may be a light emitting diode or a photocathode.

In an embodiment of the circuit carrier the assembly is in thermal contact with a heat sink. The heat sink may be part of a housing in which the circuit carrier is located. The heat sink in particular may thermally contact the assembly at the holder of the assembly. More specifically, the heat sink may contact the assembly at a side of the frame of the holder opposite the side from which the contact portion of the surface-mount device is inserted into the frame. In this way, thermal contact to the first set of electric contacts and the contact portion of the surface-mount device is possible. In a specific variant of this embodiment, the heat sink thermally contacts the assembly through an opening in the circuit carrier. Note that this would not be possible with conventionally mounted surface-mount devices. The opening for the heat sink is where the electrical contact between the surface-mount device and electric conductors on the circuit carrier would be established with conventional mounting. As with an assembly according to the invention the electrical contact to conductors of the circuit carrier is established via the second set of electric contacts outside the frame of the holder, the area within the frame, where the first set of electric contacts of the holder and the contact portion of the surface-mount device are, is accessible for other purposes, in the embodiment discussed for cooling via the heat sink.

In an embodiment, the thermal contact between the heat sink and the assembly may be established via a thermal paste or via a thermal pad.

In an embodiment the assembly is arranged on a surface on one side of the circuit carrier. An electrical connection between the second set of electric contacts of the holder of the assembly and an electric conductor of circuitry of the circuit carrier is established on the side of the circuit carrier on which the assembly is arranged.

In an embodiment the assembly is arranged such that at least part of the surface-mount device of the assembly is located within a recess in the circuit carrier. For example, the holder with the frame into which the contact portion of the surface-mount device is inserted may be arranged on a surface on one side of the circuit carrier, and an electrical connection between the second set of electric contacts of the holder of the assembly and an electric conductor of circuitry of the circuit carrier is established on the same side. A portion of the surface-mount device other than the contact portion protrudes into the recess in the circuit carrier. The material of the circuit carrier surrounding the recess, which may be a through-hole, provides mechanical protection for the portion of the surface-mount device within the recess.

In an embodiment the circuit carrier includes a plurality of assemblies according to the invention. The second set of electric contacts of the respective holder of each of the assemblies is in electrical contact with the electrical circuitry of the circuit carrier. The circuit carrier defines a plane. The frame of a first assembly of the plurality of assemblies is arranged at a first angle relative to the plane defined by the circuit carrier. The frame of a second assembly of the plurality of assemblies is arranged at a second angle relative to the plane defined by the circuit carrier. The first angle is different from the second angle. For example, in this way, plural LEDs can be mounted in assemblies on the circuit carrier in such a way that respective directions of light emission from the LEDs are different, leading to an increased overall solid angle of light emission from the circuit carrier.

Below the invention and its advantages will be discussed with reference to the accompanying drawings.
- Figure 1: shows an arrangement of surface-mount devices on a printed circuit board according to prior art.
- Figure 2: shows an LED as example of a surface-mount device.
- Figure 3: is a further view of the LED of Fig. 2.
- Figure 4: illustrates thermal problems with prior art mounting.
- Figure 5: shows a holder according to the invention.
- Figure 6: shows the insertion of an LED into a holder according to the invention.
- Figure 7: shows an assembly according to the invention,
- Figure 8: is a further view of an assembly according to the invention.
- Figure 9: shows the arrangement of an assembly according to the invention on a circuit carrier.
- Figure 10: shows a circuit carrier according to the invention.
- Figure 11: shows a circuit carrier according to the invention.
- Figure 12: shows a circuit carrier according to the invention

The figures are only examples of how the invention can be implemented and are not to be taken as a limitation of the invention to the examples shown.

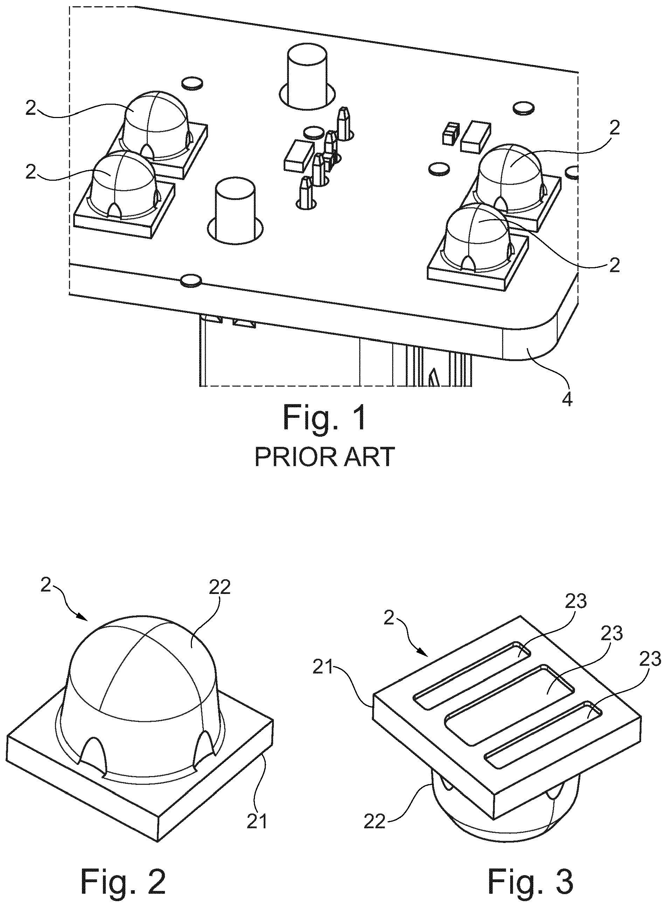

**Fig. 1** shows surface-mount devices 2, more precisely LEDs operating in the infrared range, mounted on a circuit carrier 4, more precisely a printed circuit board (PCB). The LEDs are surface-mounted in a conventional fashion according to prior art.

**Fig. 2** shows an LED as an example of a surface-mount device 2. The surface-mount device 2 has a contact portion 21, and a function portion 22. The contact portion 21 is provided for establishing an electrical contact to electric conductors, the function portion 22 is provided to fulfil an intended function of the surface-mount device 2; in the case of an LED, this function includes the emission of light.

**Fig. 3** shows a different view of the LED 2 shown in figure 2. Here electric contacts 23 in the contact portion 21 are visible. These electric contacts 23 are to be brought in contact with electric conductors in a system in which the LED 2 is to be used, for energy supply to the LED, more precisely to the function portion 22.

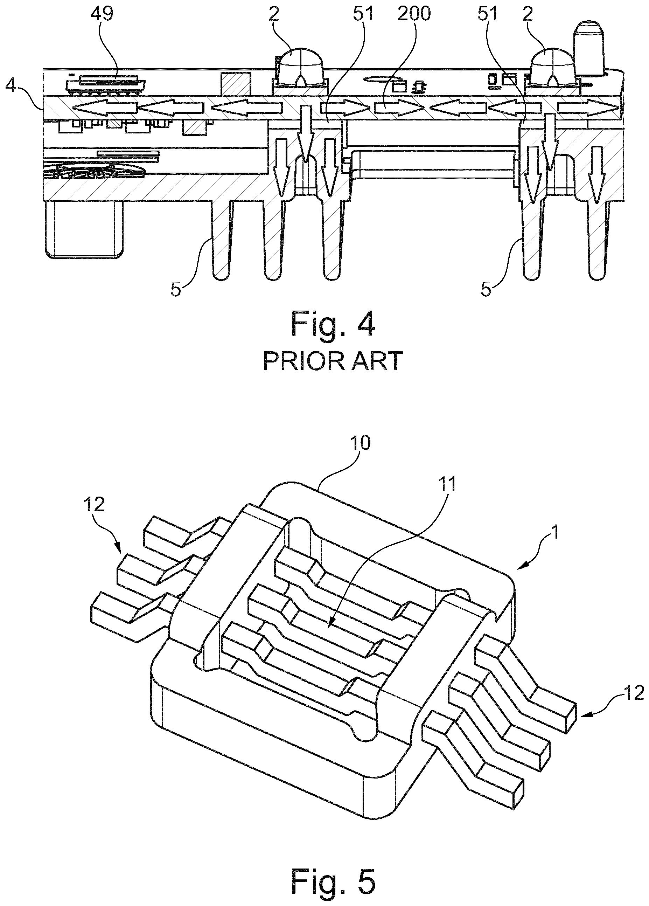

**Fig. 4** shows surface-mount devices 2, more precisely LEDs, mounted on a PCB 4 in conventional manner. Arrows 200 illustrate the heat flow from the LEDs in operation. The heat travels along the PCB 4 and may reach further components, like a camera sensor 49. If too much heat reaches a further component, the temperature there rises above a safe level, which results in damage to or at least reduced lifetime of the respective further component. The heat also travels into a heat sink 5. The heat sink 5 is in contact with the PCB 4 via thermal paste 51; alternatively, a thermal pad could be used. It should be noted that heat from the LEDs 2 has to pass through the PCB 4 before it reaches the thermal paste 51 and then the heat sink 5. As the thermal conductivity of PCBs is low, compared with for example aluminium or copper, the cooling of the LEDs 2 by the heat sink 5 is of moderate efficiency.

**Fig. 5** shows a holder 1 according to the invention. The holder 1 includes a frame 10, a first set of electric contacts 11, and a second set of electric contacts 12. The first set of electric contacts 11 is within the frame 10, i.e., within an area circumscribed by the frame 10, the second set of electric contacts 12 is outside of the frame 10, i.e., outside of the area circumscribed by the frame 10.

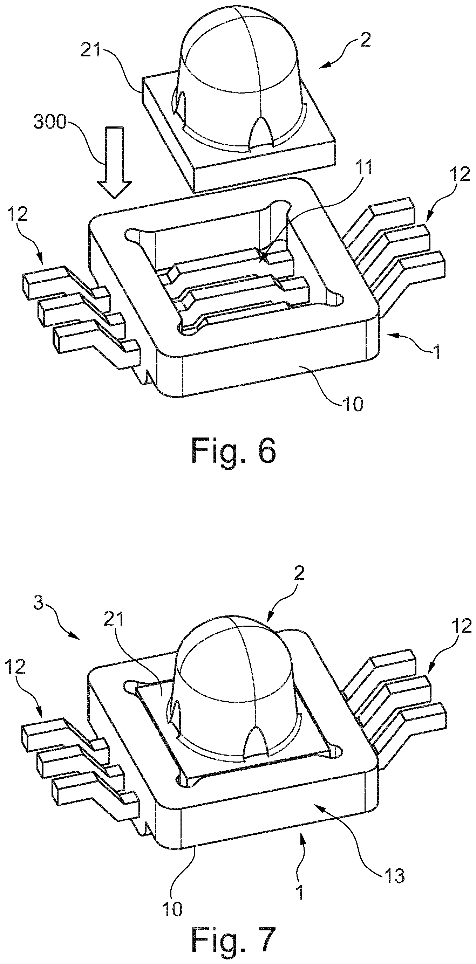

**Fig. 6** shows the insertion, along a direction 300, of an LED 2 into a holder 1. The holder 1 has a frame 10, a first set of electric contacts 11, and a second set of electric contacts 12. Upon insertion, contact portion 21 is placed within the frame 10, and its electric contacts (see Fig. 3) are in electrical connection with the first set of electric contacts 11.

**Fig. 7** shows an assembly 3 according to the invention, resulting from the insertion shown in Fig. 6. The components shown with reference signs have been mentioned in the context of Fig. 6. The contact portion 21 here is inserted into frame 10 of holder 1. The frame 10 also provides a handling surface 13, where the assembly 3 can be mechanically contacted for handling the assembly 3, for example for mounting on a circuit carrier.

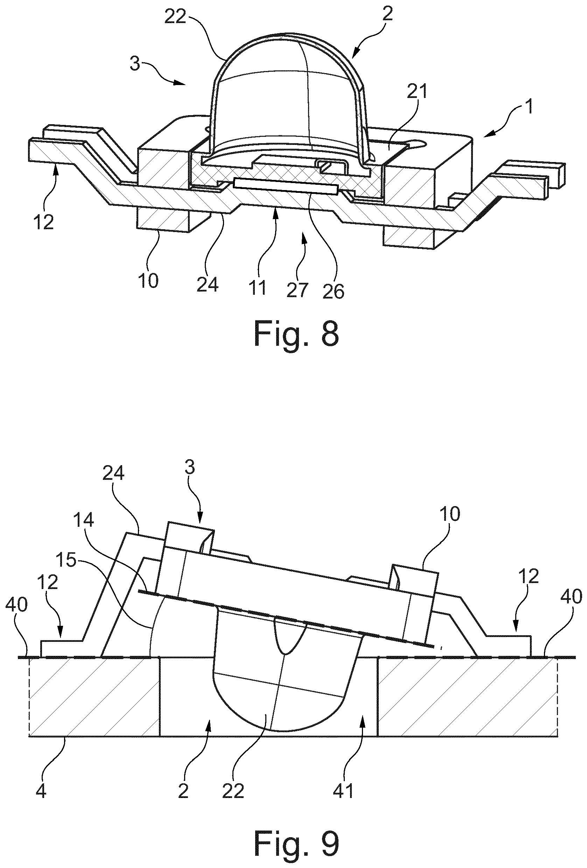

**Fig. 8** shows the assembly 3 according to the invention also shown in Fig. 7 in a section view. Shown are the surface-mount device 2 (LED) with contact portion 21 and function portion 22. Contact portion 21 is inserted into frame 10 of holder 1. The first set of electric contacts 11 is in electrical contact with the contact portion 21 via a solder connection 26. It can be seen that the first set of electric contacts 11 and the second set of electric contacts 12 are implemented via a plurality of conductor elements 24. Each conductor element 24 carries an electric contact of the first set of electric contacts 11 and two electric contacts of the second set of electric contacts 12. Clearly visible is free space 27, which is circumscribed by frame 10 on a side of the holder 1 opposite the side from which surface-mount device 2 is inserted into the frame 10. This free space 27 is available for other purposes, like cooling of the surface-mount device 2 and the first set of electric contacts 11, as the first set of electric contacts 11 and the contact portion 21 of the surface-mount device 2 are accessible via the free space 27.

**Fig. 9** shows an assembly 3 according to the invention arranged on a circuit carrier 4. The circuit carrier 4, which may be a PCB, has a recess 41 into which function portion 22 of the surface-mount device 2 is partially inserted. The material of the circuit carrier 4 surrounding recess 41 provides mechanical protection for the function portion 22. Circuit carrier 4 defines a plane 40, which is also the plane in which contact surfaces of the second set of electric contacts 12 are located to establish an electrical connection with electric conductors (not shown) on the circuit carrier 4. The frame 10 defines a plane 14. Plane 14 and plane 40 include an angle 15. The angle 15 is achieved or set by suitable shaping of conductor elements 24 carrying both the first set of electric contacts and the second set of electric contacts 12. As the surface-mount device 2 is connected to the circuit carrier 4 as part of assembly 3 via the second set of electric contacts 12, which are located at conductor elements 24 which can be shaped according to need, the surface-mount device 2 can be arranged on the circuit carrier 4 in a tilted manner, i.e., with angle 15 different from zero. In case the surface-mount device 2 is an LED, this implies that a direction of light emission relative to the circuit carrier 4 can be set according to need in an easy manner.

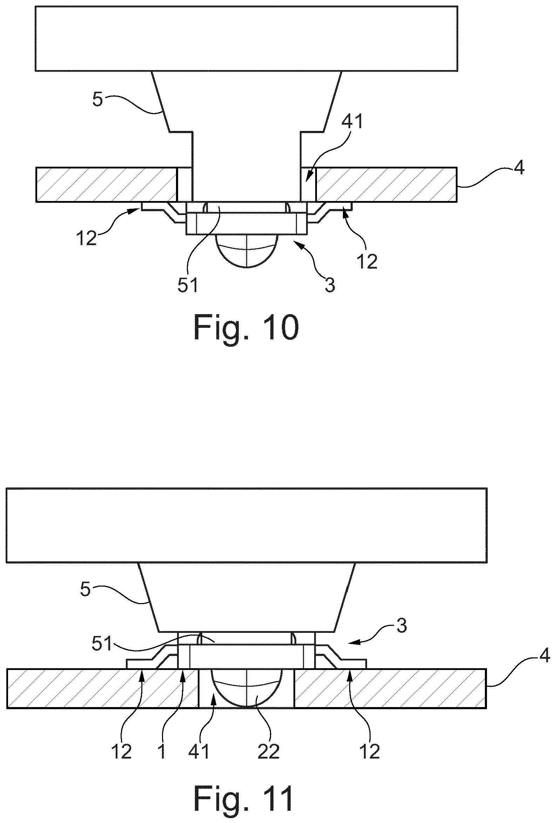

**Fig. 10** shows a circuit carrier 4 according to the invention, with an assembly 3 according to the invention. The circuit carrier 4 has a recess 41. The assembly 3 is entirely arranged on one side of the circuit carrier 4, and electrical connections between electric conductors (not shown) on the circuit carrier 4 and the second set of electric contacts 12 are established on this same side of the circuit carrier 4. The assembly 3 is in thermal contact with a heat sink 5 via thermal paste 51. Heat sink 5 extends into recess 41 to contact the assembly 3 via the thermal paste 51. Thermal paste 51 is located in free space 27 (see Fig. 8).

**Fig. 11** shows a circuit carrier 4 according to the invention, with an assembly 3 according to the invention. The circuit carrier 4 has a recess 41. Holder 1 of assembly 3 is arranged on one side of the circuit carrier 4, and electrical connections between electric conductors (not shown) on the circuit carrier 4 and the second set of electric contacts 12 are established on this same side of the circuit carrier 4. A function portion 22 of the surface-mount device of the assembly 3 extends into the recess 41. The assembly 3 is in thermal contact with a heat sink 5 via thermal paste 51. Thermal paste 51 is located in free space 27 (see Fig. 8).

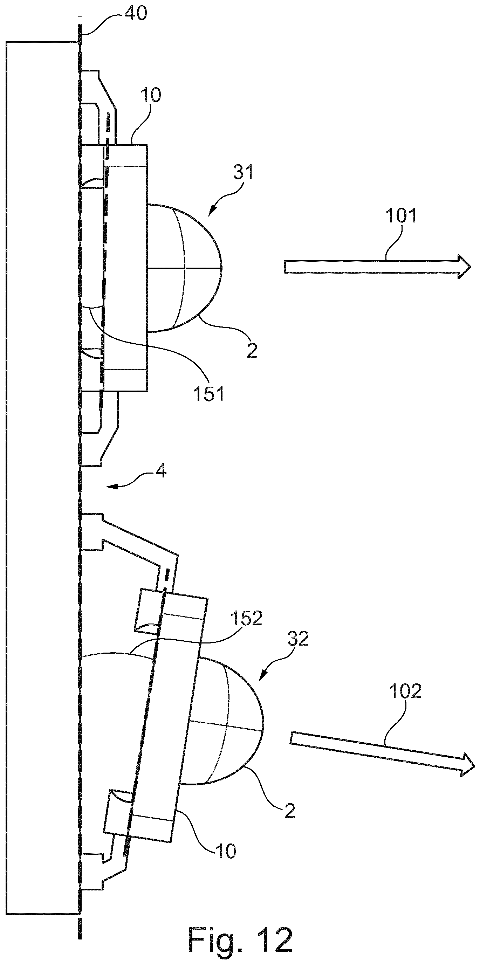

**Fig. 12** shows a circuit carrier 4 according to the invention with a first assembly 31 according to the invention and a second assembly 32 according to the invention. The circuit carrier 4 defines a plane 40. The frame 10 of the first assembly 31 includes a first angle 151 with the plane 40 defined by the circuit carrier 4 (in the example shown, this first angle is zero). The frame 10 of the second assembly 32 defines a second angle 152 with the plane 40 defined by the circuit carrier 4. The second angle 152 is different from the first angle 151. The surface-mount devices 2 of the first assembly 31 and the second assembly 32 here are LEDs. Shown is a direction 101 about which light emission from LED 2 of first assembly 31 is symmetric, and a direction 102 about which light emission from LED 2 of second assembly 32 is symmetric; light emission in each case is into a cone symmetric about the directions 101 and 102, respectively. Due to the differing angles 151, 152, these directions 101, 102 of light emission are different, increasing the total angle of light emission from the circuit carrier 4. The mounting of the surface-mount devices 2 with differing angles 151, 152 would not be possible with conventional mounting. By using the surface-mount devices 2 in assemblies 31, 32 according to the invention, however, this can be achieved in an easy manner.

### List of Reference Signs

- 1: holder
- 2: surface-mount device
- 3: assembly
- 4: circuit carrier
- 5: heat sink
- 10: frame
- 11: first set of electric contacts
- 12: second set of electric contacts
- 13: handling surface
- 14: plane
- 15: angle
- 21: contact portion
- 22: function portion
- 23: electric contacts
- 24: conductor element
- 26: solder connection
- 27: free space
- 31: first assembly
- 32: second assembly
- 40: plane
- 41: recess
- 49: camera sensor
- 51: thermal paste
- 101: direction
- 102: direction
- 151: first angle
- 152: second angle
- 200: arrow (heat flow)
- 300: direction

## Claims

1. Holder (1) for a surface-mount device (2), the holder (1) including
a frame (10) for receiving a contact portion (21) of the surface-mount device (2) within the frame (10);
a first set of electric contacts (11) within the frame (10), for electrically contacting the contact portion (21) of the surface-mount device (2);
a second set of electric contacts (12) outside of the frame (10), for electrically connecting to electric conductors external to the holder (1), the second set of electric contacts (12) in electrical connection with the first set of electric contacts (11).

2. Holder (1) according to claim 1, wherein the second set of electric contacts (12) defines a plane (40) and an angle (15) of the frame (10) relative to this plane (40) is adjustable.

3. Assembly (3) including:
a holder (1) according to claim 1 or 2;
a surface-mount device (2) with a contact portion (21) of the surface-mount device (2) inserted into the frame (10) and in electrical contact with the first set of electric contacts (11).

4. Circuit carrier (4) including
electrical circuitry;
an assembly (3) according to claim 3;
wherein the second set of electric contacts (12) of the holder (1) is in electrical connection with one or more electric conductors of the electrical circuitry.

5. Circuit carrier (4) according to claim 4, wherein the circuit carrier (4) is a printed circuit board.

6. Circuit carrier (4) according to claim 4 or 5, wherein the surface-mount device (2) in the assembly (3) is a light emitting diode.

7. Circuit carrier (4) according to claim 4 or 5, wherein the surface-mount device (2) in the assembly (3) is a photocathode.

8. Circuit carrier (4) according to one of the claims 4-7, wherein the assembly (3) is in thermal contact with a heat sink (5).

9. Circuit carrier (4) according to claim 8, wherein the thermal contact is established via thermal paste (51) or via a thermal pad.

10. Circuit carrier (4) according to one of the claims 4-9, wherein the assembly (3) is arranged on a surface on one side of the circuit carrier (4) and an electrical connection between the second set of electric contacts (12) of the holder (1) of the assembly (3) and an electric conductor of circuitry of the circuit carrier (4) is established on the side of the circuit carrier (4) on which the assembly (3) is arranged.

11. Circuit carrier (4) according to one of the claims 4 - 9, wherein the assembly (3) is arranged such that at least part of the surface-mount device (2) of the assembly (3) is located within a recess (41) in the circuit carrier (4).

12. Circuit carrier (4) according to one of the claims 4 - 11,
including a plurality of assemblies (31, 32) according to claim 3, the second set of electric contacts (12) of the respective holder (1) of each of the assemblies (31, 32) in electrical contact with the electrical circuitry;
the frame (10) of a first assembly (31) of the plurality of assemblies arranged at a first angle (151) relative to a plane (40) defined by the circuit carrier (4);
the frame (10) of a second assembly (32) of the plurality of assemblies arranged at a second angle (152) relative to the plane (40) defined by the circuit carrier (4);
wherein the first angle (151) is different from the second angle (152).
